**Europäisches Patentamt**

**European Patent Office**

**Office européen des brevets**

(11) Numéro de publication: **0 227 551 B1**

(12) **FASCICULE DE BREVET EUROPEEN**

(45) Date de publication du fascicule du brevet:
31.10.90

(51) Int. Cl.⁵: **H03K 4/50, H04N 5/10**

(21) Numéro de dépôt: **86402863.4**

(22) Date de dépôt: **19.12.86**

(54) Circuits de fourniture d'un signal de balayage vertical pour téléviseur.

(30) Priorité: **24.12.85 FR 8519124**

(43) Date de publication de la demande:
**01.07.87 Bulletin 87/27**

(45) Mention de la délivrance du brevet:
**31.10.90 Bulletin 90/44**

(84) Etats contractants désignés:
**DE FR GB IT NL**

(56) Documents cités:
**EP-A- 0 136 758**
**US-A- 3 855 496**
**US-A- 4 334 174**
**US-A- 4 535 353**

(73) Titulaire: **THOMSON-CSF, 51, Esplanade du Général de Gaulle, F-92800 Puteaux(FR)**

(72) Inventeur: **Van Den Driessche, Michel, THOMSON-CSF SCPI 19, avenue de Messine, F-75008 Paris(FR)**

(74) Mandataire: **de Beaumont, Michel et al, 1bis, rue Champollion, F-38000 Grenoble(FR)**

**Description**

La présente invention concerne des procédés et circuits de fourniture d'un signal de balayage vertical.

Plus particulièrement, la présente invention concerne de tels procédés et circuits de fourniture d'un circuit de balayage vertical qui soient optimisés dans le cas d'un téléviseur fonctionnant en réception directe.

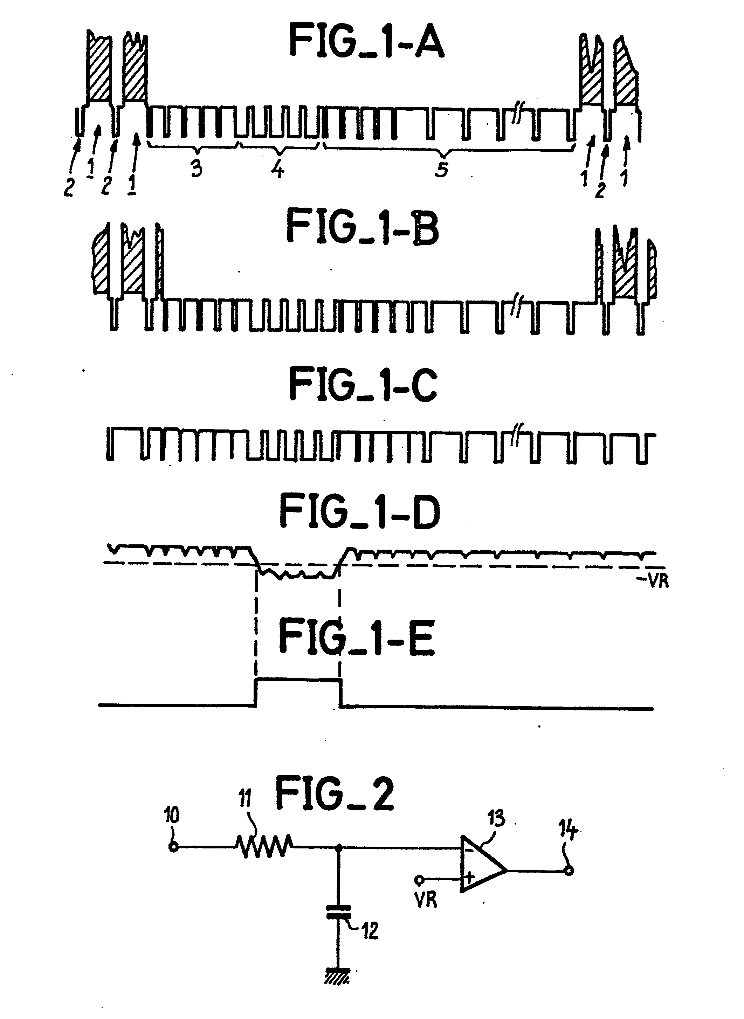

De façon générale, et en négligeant les fréquences porteuses, un téléviseur reçoit un signal vidéo composite tel que représenté en figures 1A et 1B. L'image est transmise en deux trames entrelacées.

Comme le représente la figure 1A, la fin d'un signal de trame, comprenant des signaux vidéo composites 1 correspondant à une ligne de balayage séparés par des impulsions de synchronisation de ligne 2, est suivie d'une zone où seuls des signaux de synchronisation sont émis. Ces signaux de synchronisation comprennent des signaux dits de présynchronisation de trame 3, des signaux de synchronisation de trame 4 et des signaux dits de postsynchronisation de trame 5, après quoi les signaux vidéo 1 séparés par les impulsions de synchronisation de ligne 2 (ou synchronisation horizontale) reprennent.

La figure 1B représente les signaux de synchronisation de trame après la fin d'une trame impaire, si la figure 1A représentait la fin d'une trame paire. On notera que les signaux de synchronisation horizontale sont déphasés de la moitié de la période de balayage horizontal.

De façon classique, on cherche à extraire les signaux de synchronisation de ligne et de trame. Dans un premier temps, on extrait ce qui est appelé un signal de synchronisation de ligne composite tel que représenté en figure 1C, résultant des signaux des figures 1A ou 1B par écrêtage. Ensuite, une intégration à constante de temps longue devant la durée des signaux de synchronisation horizontale fournit un signal de synchronisation de trame représenté en figure 1D qui est mis en forme de la façon représentée en figure 1E, par exemple par comparaison avec une tension de seuil -VR indiquée en figure 1D.

Un circuit classique élémentaire pour extraire le signal de synchronisation de trame du signal de synchronisation de ligne composite est illustré en figure 2. Si le signal de synchronisation de ligne composite est appliqué à l'entrée 10 de ce circuit, on obtient le signal de la figure 1D à l'aide d'un circuit intégrateur comprenant une résistance 11 et un condensateur 12. Ce signal est appliqué à un comparateur 13 dont l'autre entrée reçoit une tension de référence VR et le signal de la figure 1E, le signal de synchronisation de trame, est obtenu à la sortie 14 du comparateur 13.

Un tel circuit a été présenté uniquement à titre d'exemple, pour faire comprendre les problèmes que visera à résoudre la présente invention mais il est clair qu'il n'est pas adapté à une réalisation sous forme de circuit intégré car il nécessite la présence d'un condensateur 12 de forte valeur.

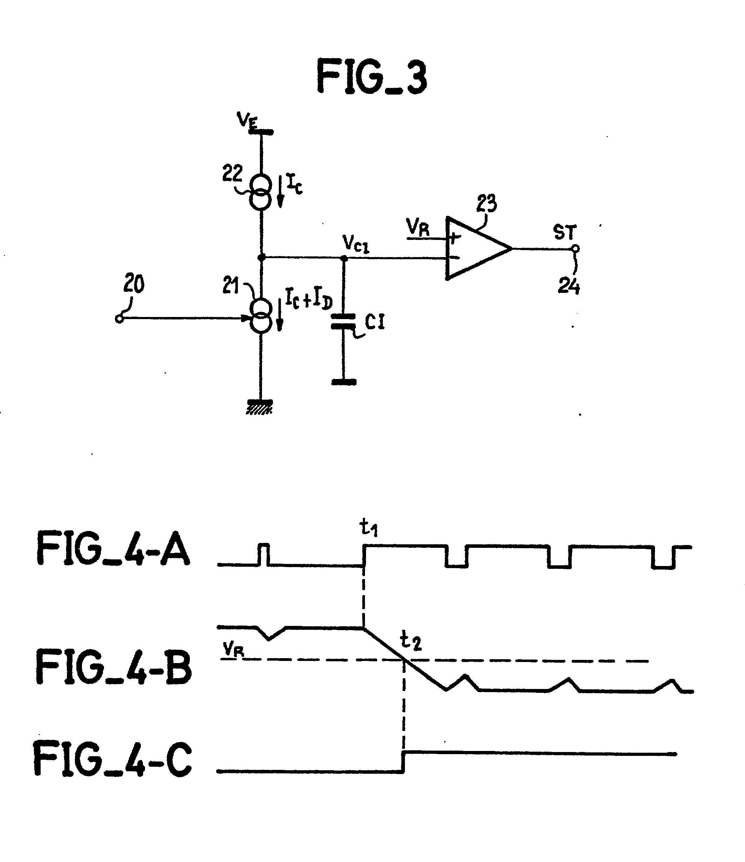

Pour la réalisation d'une circuit d'extraction de signal de synchronisation de trame en circuit intégré, on choisit plutôt un circuit du type de celui de la figure 3. Le signal de synchronisation de ligne composite appliqué à l'entrée 20 de ce circuit commande la conduction ou la non-conduction d'une source de courant 21. La source de courant 21 est connectée d'une part à la masse, d'autre part à une tension d'alimentation VE par l'intermédiaire d'une source de courant 22 dirigée dans le même sens que la source de courant 21. Le point de raccordement des sources de courant 21 et 22 est connecté, d'une part, à une première entrée d'un comparateur 23 dont la deuxième entrée reçoit une tension de référence VR et, d'autre part, à une borne d'un condensateur de faible valeur C1 dont l'autre borne est connectée à la masse.

Le fonctionnement du circuit de la figure 3 est le suivant. Quand l'entrée 20 inhibe la source de courant 21, la source de courant 22 charge le condensateur C1 par un courant IC jusqu'à ce que la tension à ses bornes, VC1, atteigne la tension VE. Quand l'entrée 20 valide la source de courant 21, celle-ci entraîne le passage d'un courant IC + ID, c'est-à-dire que le condensateur C1 se décharge à courant constant ID jusqu'à ce que VC1 atteigne le potentiel de la masse ou que la source de courant 21 soit à nouveau inhibée. Le signal à la sortie 24 du comparateur 23 est le signal de synchronisation de trame ST.

Les figures 4A à 4C illustrent les formes des signaux apparaissant en différents points du circuit de la figure 3. La figure 4A représente le signal de synchronisation de ligne composite à la borne 20. Pendant toute la durée de l'image et la durée des signaux de présynchronisation trame, le signal 20 est de façon générale à bas niveau sauf pendant de brefs instants au moment des tops de synchronisation ligne. Par contre, à partir de l'instant t1 de début de la période de synchronisation de trame, les périodes à haut niveau sont longues devant les périodes à bas niveau.

La figure 4B représente la tension VC1 aux bornes du condensateur C1. On peut voir qu'avant l'instant t1, pendant les tops de synchronisation ligne, le condensateur C1 n'a pas le temps de se décharger au point que la tension VC1 atteigne la tension de référence VR. C'est seulement à partir de l'instant t1 que cette tension VC1 décroît suffisamment, pour atteindre la tension de référence VR à l'instant t2.

La figure 4C représente le signal à la sortie du comparateur 23. Ce signal de synchronisation de trame ST change d'état à l'instant t2.

De façon classique, c'est ce changement d'état que l'on utilise directement comme signal de synchronisation trame pour commander à cet instant t2 l'inversion de sens de la dent de scie de balayage vertical appliquée aux bobines de déviation verticale du téléviseur.

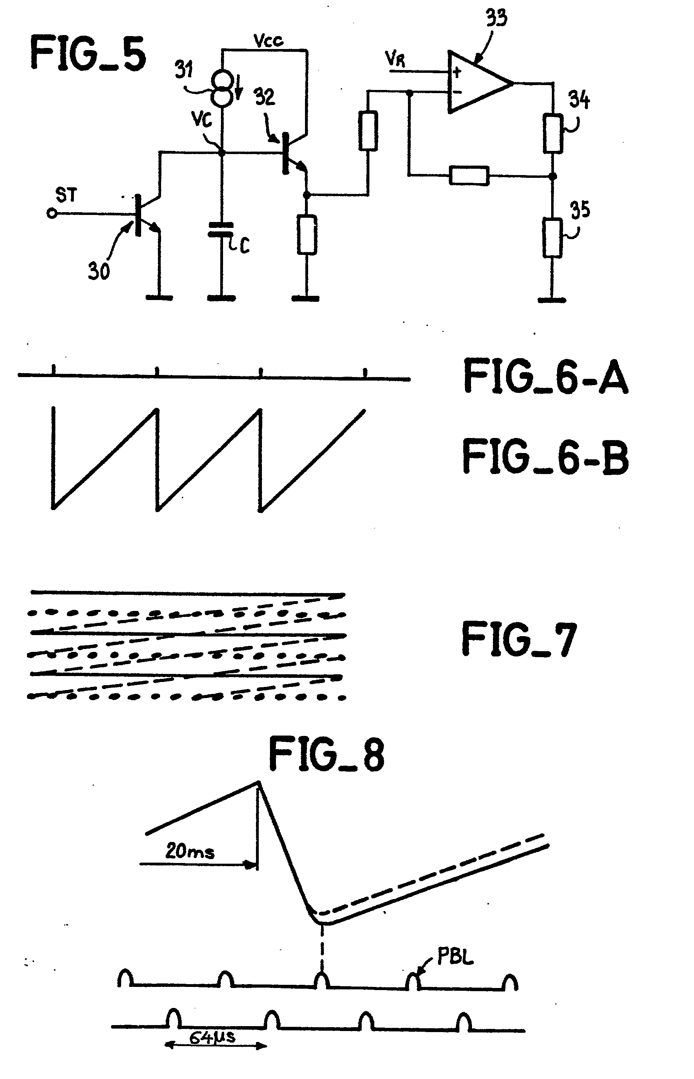

La figure 5 représente un circuit classique de commande de déviateur vertical. Le signal de synchronisation de trame ST est appliqué à l'entrée d'un générateur de dents de scie, plus particulièrement à la base d'un transistor 30 dont l'émetteur est relié à la masse et le collecteur à une première borne d'un condensateur C dont l'autre borne est reliée à la masse. Ce condensateur se charge sous l'effet d'une source de courant 31 et sa tension est transmise, par un transistor 32 monté en émetteur-suiveur, à un amplificateur de puissance 33. La sortie de cet amplificateur de puissance 33 alimente une bobine de déviation verticale 34, généralement en série avec une résistance de mesure de courant 35.

La figure 6A représente à une échelle plus petite que celle des figures précédentes des signaux de synchronisation de trame successifs. La figure 6B représente la tension VC aux bornes du condensateur C, qui est appliquée par l'intermédiaire du circuit amplificateur à la bobine de déviation. En l'absence du signal ST, le condensateur C se charge et la tension VC croît progressivement pour chuter brutalement dès que le signal ST est appliqué à la base du transistor 30 et recommencer à croître quand le signal ST est interrompu.

La figure 7 représente des lignes de balayage successives sur un téléviseur. Les lignes en traits pleins indiquent le balayage des trames impaires et les lignes en traits pointillés gras indiquent le balayage des lignes des trames paires. En pointillés légers sont indiquées les traces de retour ligne. Il est important que les lignes d'une trame paire soient exactement centrées entre les lignes d'une trame impaire. Un effet optique déplaisant apparaît pour le téléspectateur dès qu'un décentrage de l'ordre de 10 % se produit. Normalement, les signaux de synchronisation trame de deux trames successives sont décalés de façon à ce que les dents de scie successives des trames paire et impaire soient elles-même convenablement décalées.

On notera, toutefois, qu'un décalage de 10 % doit correspondre à un réglage très précis du point de démarrage de la montée de la dent de scie de balayage vertical. En effet, si la dent de scie a une amplitude de 2 V, la précision que l'on doit atteindre est de $2/10 \times 625 = 3,2\ 10^{-4}$ V ou 0,3 mV. On conçoit qu'une telle précision soit difficile à atteindre notamment si l'on tient compte de ce que les divers composants des circuits déterminant les constantes de temps de la dent de scie et son amplitude peuvent varier en fonction de la température, du vieillissement et de leur valeur initiale d'un téléviseur à un autre.

En outre, le balayage horizontal du téléviseur (balayage ligne) nécessite des courants de valeur importante avec des variations de courant élevées pendant les retours lignes. Ces impulsions de retour ligne produisent une pollution importante des circuits de masse pendant la durée du retour ligne (courant de masse, rayonnement électromagnétique). Comme le montre la figure 8, si une impulsion résultant d'un parasite de balayage ligne PBL se produit au moment où la dent de scie de balayage trame commence à remonter, au lieu d'avoir la dent de scie prévue indiquée en trait plein dans la courbe supérieure de la figure 8, on obtient l'allure représentée en pointillés, c'est-à-dire un décalage de toutes les lignes de cette trame. Dans ce cas, la trame suivante ne sera pas affectée du même décalage car le début de charge aura lieu entre deux parasites. Il en résulte trame à trame un décalage du niveau de la dent de scie et donc l'apparition d'un défaut visible pour le téléspectateur.

Un objet de la présente invention est de prévoir un procédé et des circuits de fourniture de signal de commande de dent de scie de balayage de trame permettant d'éviter ces inconvénients.

Un objet de la présente invention est de prévoir un circuit permettant d'atteindre un tel résultat quand un téléviseur fonctionne en réception normale.

Pour atteindre ces objets ainsi que d'autres, la présente invention prévoit un procédé de fourniture de signal en dent de scie de balayage vertical pour téléviseur à partir des signaux de synchronisation ligne et trame contenus dans un signal vidéo composite, et plus particulièrement d'un signal H/2 à la fréquence double des signaux de synchronisaton horizontale présentant une relation de phase déterminée avec les signaux de balayage horizontal, un front du signal H/2 ne coïncidant pas avec la durée de retour ligne du balayage horizontal. Ce procédé consiste, pendant la durée du signal de synchronisation de trame, à :

déclencher la descente du signal en dent de scie de balayage au moment de la première apparition dudit front du premier signal H/2,

maintenir la dent de scie à bas niveau jusqu'à la deuxième, troisième, ou autre apparition ultérieure dudit front du signal H/2 ;

déclencher la remontée de la dent de scie au moment de ladite troisième ou autre apparition dudit front du signal H/2.

La présente invention prévoit également un circuit de commande pour la fourniture d'un signal en dent de scie de balayage vertical de téléviseur comprenant : un intégrateur d'entrée recevant le signal de synchronisation ligne composite et fournissant un signal de synchronisation de trame (ST), et une suite de bascules commandée par la présence du signal (ST) et par un signal à la fréquence double du signal de balayage de ligne (H/2) pour fournir un signal de commande de dent de scie de trame à bas niveau en l'absence du signal (ST) et à haut niveau en présence du signal (ST) et à partir du front de montée d'une première impulsion dudit signal à fréquence double (H/2) jusqu'au front de montée de la troisième impulsion dudit signal à fréquence double (H/2).

Dans un mode de réalisation, la suite de bascules comprend trois bascules :
- une première bascule recevant sur son entrée S la sortie d'une porte ET recevant elle-même le signal de synchronisation de trame (ST) et le signal à fréquence double (H/2), recevant sur son entrée R le signal (ST) inversé, et fournissant sur sa sortie Q un signal (STN),
- une seconde bascule recevant le signal (STN) et founissant un signal de durée brève (RAZ) sur sa sortie Q,
- une troisième bascule recevant la sortie de la seconde bascule sur son entrée S et des signaux logiques en provenance d'un diviseur à 10 bits du signal H/2 sur son entrée R pour amener la sortie Q de cette bascule à bas niveau lors de la troisième apparition d'un signal à fréquence double (H/2).

Dans un mode de réalisation, la sortie (STN) de la première bascule est appliquée à l'entrée de la seconde bascule par l'intermédiaire d'une porte ET recevant aussi un signal de fenêtre (F) pour permettre l'application d'un signal sur la deuxième bascule seulement pendant la durée où il est possible qu'apparaisse normalement un signal (ST).

Dans un mode de réalisation, la sortie (STN) de la première bascule est transmise à l'entrée de la deuxième bascule par l'intermédiaire d'une porte OU recevant sur sa deuxième entrée un signal (TL) fourni par des circuits logiques du téléviseur à partir du signal (H/2) pour déclencher la deuxième bascule peu après l'instant probable d'apparition du signal de synchronisation de trame (ST) au cas où ce signal n'aurait pas été fourni.

Dans un mode de réalisation, la sortie (RAZ) de la seconde bascule est appliquée aux entrées de remise à zéro d'un ensemble de diviseurs par deux connectés séquentiellement et recevant à leur entrée le signal à fréquence double (H/2) pour fournir une succession de signaux logiques qui, combinés de diverses manières, peuvent assurer diverses fonctions de synchronisation pour les circuits du téléviseur.

Dans un mode de réalisation, le circuit de génération de dent de scie recevant le signal de sortie de la troisième bascule comprend un condensateur en série avec une source de courant et en parallèle avec un transitor de court-circuit ; la borne commune à la source de courant et au condensateur est reliée par l'intermédiaire d'un circut adaptateur à un comparateur effectuant une comparaison avec une tension de seuil (VS) ; le signal de sortie de la troisième bascule est appliqué à la source de courant et au comparateur du circuit de génération de dent de scie pour les valider quand ce signal est à haut niveau.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1 à 8 destinées à exposer le domaine de la présente invention et l'état de la technique ont été décrites précédemment ;
la figure 9 représente de façon schématique un mode de réalisation d'un circuit selon la présente invention pour la réception directe de signaux de télévision ; et
la figure 10 représente des signaux apparaissant en divers points du circuit de la figure 9.

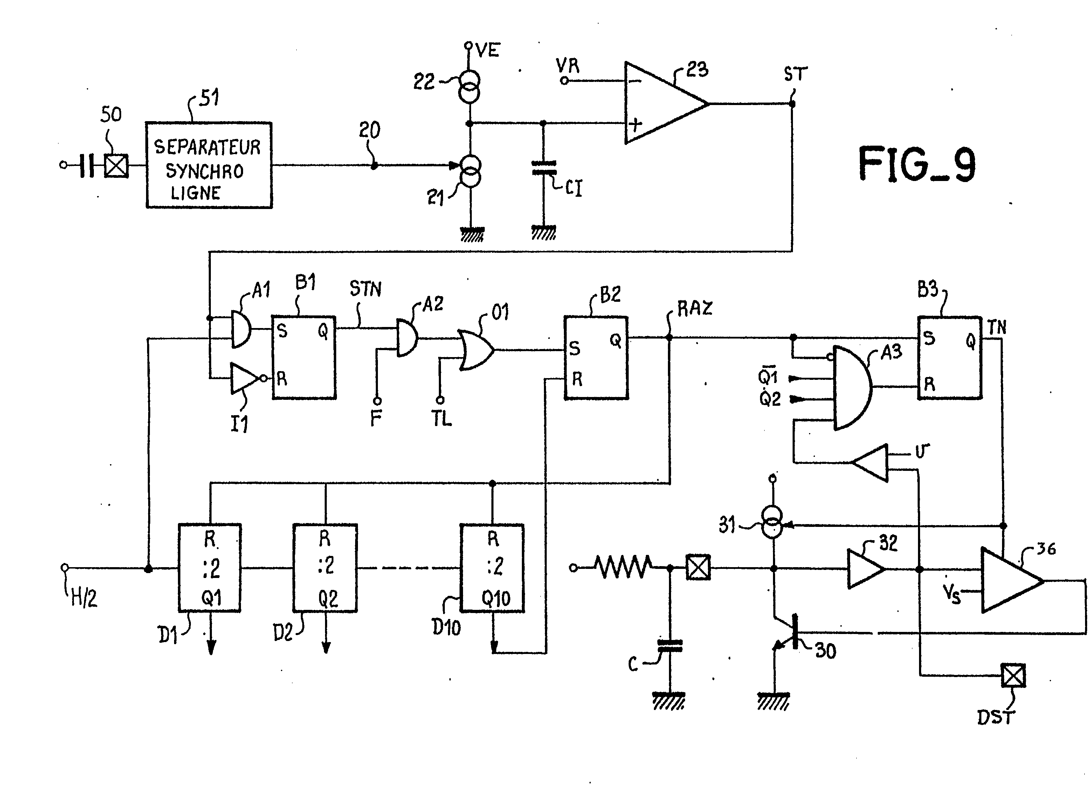

Le circuit de la figure 9 reçoit à sa borne d'entrée 50, le signal vidéo composite par l'intermédiaire d'un condensateur de couplage. Un circuit 51 agit comme séparateur de synchronisation ligne pour fournir le signal de synchronisation ligne composite appliqué à un circuit du type déjà décrit en relation avec la figure 3 et dans lequel de mêmes éléments sont indiqués par de mêmes références : entrée 20, sources de courant 21 et 22, condensateur C1, et comparateur 23 fournissant à sa sortie un signal de synchronisation trame ST.

Le signal ST est fourni à l'entrée S d'une bacule B1 par l'intermédiaire d'une porte ET A1 dont l'autre entrée reçoit un signal H/2 à fréquence double des tops de synchronisation ligne et en relation de phase avec les impulsions de retour ligne. Le signal ST est également appliqué à l'entrée R de la bascule B1 par l'intermédiaire d'un inverseur I1.

La sortie Q de la bascule B1 est transmise à l'entrée S d'une bascule B2 par l'intermédiaire d'une porte ET A2 et d'une porte OU O1. L'autre entrée de la porte ET A2 reçoit un signal de fenêtre F et l'autre entrée de la porte OU O1 reçoit un signal TL (top de fréquence libre).

Les signaux F et TL sont fournis à partir d'une succession de diviseurs par deux D1 à D10 recevant les signaux H/2 précédemment mentionnés. Le signal de fenêtre correspond à une période pendant laquelle le signal de synchronisation trame est susceptible de se produire pour éviter que la porte ET A2 ne transmette un signal qui se produirait en dehors de la période de synchronisation de trame. Le signal TL est un top fourni par comptage des impulsions de synchronisation ligne successives pour faire fonctionner le circuit et déclencher le balayage de trame dans le cas où, dans le signal émis, ce signal de synchronisation de trame serait noyé dans du bruit ou brouillé pour diverses raisons. La sortie du dernier diviseur Q10, ou plutôt son inverse Q̄10, est appliquée comme signal de remise à zéro à l'entrée R de la bascule B2.

La sortie Q de la bascule B2 (signal RAZ) est appliquée à l'entrée S d'une bascule B3 dont l'entrée R reçoit cette même sortie Q de la bascule B2 inversée et transmise par l'intermédiaire d'une porte ET A3 dont les autres entrées reçoivent divers signaux de validation tels que des signaux Q̄1 et Q2 en provenance des diviseurs D1 et D2. La sortie Q de la bascule B3 est un signal TN (commande du générateur de dent de scie trame) qui servira à commander la dent de scie de balayage vertical.

Dans le circuit de fourniture de dent de scie de balayage vertical, on retrouve des composants déjà décrits en figure 5 et ayant les mêmes fonctions, à savoir un transistor 30 pour court-circuiter temporairement le condensateur C chargé par une source de courant 31, la tension VC aux bornes du condensateur C étant transmise par un circuit adaptateur ou transistor en émetteur-suiveur 32 à un comparateur 36. Ce comparateur 36 est muni d'une entrée de validation qui reçoit le signal TN. C'est la sortie de ce comparateur qui commande le transistor 30, c'est-à-dire la mise en court-circuit et la décharge du condensateur C. On notera que le signal TN est également appliqué à la source de courant 31 pour l'inhiber quand il est à haut niveau. C'est le signal de sortie de l'émetteur-suiveur 32 qui constitue la borne d'alimentation de la bobine de déviation. La sortie de cet émetteur-suiveur 32 est également appliquée, par l'intermédiaire d'un comparateur à une tension de seuil v, à une quatrième entrée de la porte ET A3.

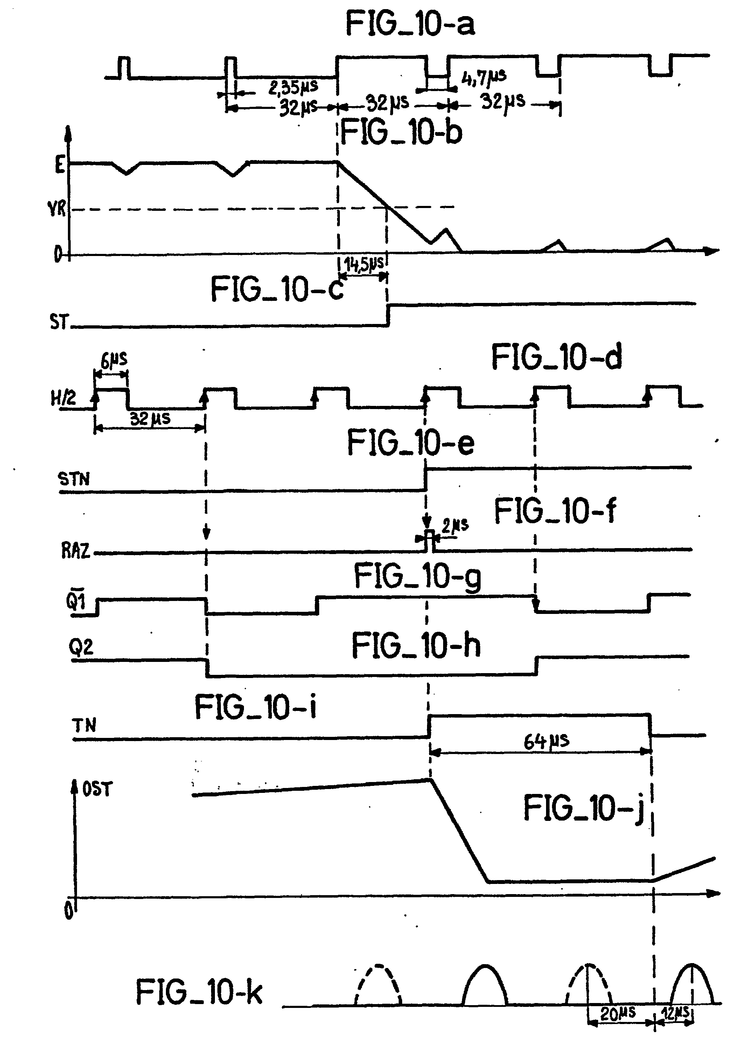

Le fonctionnement du circuit de la figure 9 va maintenant être exposé en relation avec les diagrammes de temps de la figure 10.

En figure 10, la courbe 10a représente le signal de synchronisation de ligne composite présent au point 20 du circuit. La courbe 10a indique de façon détaillée les durées des diverses phases de ce signal. On se référera à la figure pour lire ces valeurs.

La courbe 10b indique l'allure de la tension VC1 aux bornes du condensateur C1 ainsi que la tension VR présente à la deuxième entrée du comparateur 23. Comme on peut le voir, la durée normale, dans l'exemple représenté, du retard entre le début de la première impulsion de synchronisation de trame et l'instant où VC1 devient égal à VR est égale à 14,5 ms. Toutefois, cette durée peut varier et c'est en particulier de ces fluctuations que l'on veut s'affranchir.

La figure 10c représente le signal ST présent à la sortie du comparateur 23 qui passe à niveau haut quand la tension VC1 devient égale à la tension VR.

La figure 10d représente le signal H/2 appliqué à la deuxième entrée de la porte ET A1 dont la première entrée reçoit le signal ST. Ce signal H/2 est généré à partir des tops de synchronisation de ligne et sert également par ailleurs à déterminer les signaux de balayage ligne. Il y a donc une relation de phase déterminée entre les signaux H/2 et les périodes de retour ligne qui provoquent, comme on l'a indiqué précédemment, des perturbations dans l'ensemble du circuit représentées sur la figure 10k.

Ainsi, la porte ET A1 fournit un signal à haut niveau dès l'apparition du front de montée de la première impulsion H/2 qui suit le passage à haut niveau du signal ST. Il en résulte, comme le montre la figure 10e, à la sortie de la bascule B1 un signal STN de synchronisation de trame numérique qui passe à haut niveau avec ce front de montée de l'impulsion H/2. La bascule B2, comme le montre la figure 10f, fournit une impulsion brève RAZ et sert à remettre à zéro tous les diviseurs D1 à D10 et à commander l'entrée S de la bascule B3. Le signal RAZ a, par exemple, une durée de 2 microsecondes.

La courbe 10g représente la sortie Q̄1 du diviseur D1 qui passe immédiatement à haut niveau après l'application de signal de remise à zéro puisque l'on se trouve pendant un niveau haut du signal H/2.

La courbe 10h représente la sortie Q2 du diviseur D2 qui passe à haut niveau lors de l'impulsion suivante du signal H/2 (c'est-à-dire 32 microsecondes plus tard). On notera que le signal Q̄1 passe à nouveau à haut niveau pour l'impulsion encore suivante du signal H/2 (c'est-à-dire 64 microsecondes plus tard).

La bascule B3 fournit, elle, le signal TN que l'on cherche à obtenir et qui sera utilisé pour la commande de la dent de scie de balayage. La bascule B3, commandée par le signal RAZ de sortie de la bascule B2, passe à haut niveau en même temps que les signaux STN et RAZ. Elle est remise à zéro par les entrées présentes sur la porte ET A3 c'est-à-dire Q̄1 et Q2. Cette remise à zéro s'effectue donc 64 microsecondes (ou autre multiple de 32 microsecondes) après la mise à 1.

La courbe 10j représente la dent de scie de trame (DST) appliquée au déviateur vertical. Cette dent de scie voit sa tension diminuer au moment du passage à haut niveau des signaux STN, RAZ et TN et décroît rapidement au rythme déterminé par la décharge du condensateur C dans le transistor 30. Cette décharge s'arrête à une certaine tension de seuil VS qui est la tension appliquée à la deuxième entrée du comparateur 36, par exemple 1,26 V. Ensuite, la source de courant 31 étant inhibée par le signal TN, le signal DST reste à zéro jusqu'à la fin de l'impulsion TN. C'est à ce moment seulement que la dent de scie commence à croître. Cette croissance a lieu, comme on l'a vu précédemment, simultanément avec un front de montée du signal H/2 qui est en relation de phase choisie avec les périodes de retour ligne pour que les retours ligne ne se produisent pas à cet instant. Il est donc certain que le départ de la dent de scie ne sera pas parasité et donc que le phénomène de décalage des lignes horizontales des trames paires et impaires ne peut se produire.

On comprendra maintenant que la quatrième entrée de la porte ET A3 est une entrée de validation qui empêche que la dent de scie commence à se recharger tant que sa décharge n'a pas été complète, c'est-à-dire qu'elle n'a pas atteint un niveau de tension v prédéterminé.

**Revendications**

1. Procédé de fourniture de signal en dent de scie de balayage vertical ou balayage de trame pour téléviseur à partir des signaux de synchronisation ligne et trame contenus dans un signal vidéo composite, et plus particulièrement d'un signal H/2 à la fréquence double des signaux de synchronisation horizontale présentant une relation de phase déterminée avec les signaux de balayage horizontal, un front du signal H/2 ne coïncidant pas avec la durée de retour ligne du balayage horizontal, caractérisé en ce que, pendant la durée du signal de synchronisation de trame, il consiste à :
- déclencher la descente du signal en dent de scie de balayage au moment de la première apparition dudit front du premier signal H/2,
- maintenir la dent de scie à bas niveau jusqu'à la deuxième, troisième, ou autre apparition ultérieure dudit front du signal H/2 ;
- déclencher la remontée de la dent de scie au moment de ladite apparition ultérieure dudit front du signal H/2.

2. Circuit de commande pour la fourniture d'un signal en dent de scie de balayage vertical de téléviseur, comprenant un intégrateur d'entrée (20-23) recevant le signal de synchronisation ligne composite et fournissant un signal de synchronisation de trame (ST), caractérisé en ce qu'il comprend en outre une suite de bascules (B1, B2, B3) commandée par la présence du signal (ST) et par un signal à la fréquence double du signal de balayage de ligne (H/2), pour fournir un signal de commande de dent de scie de trame à bas niveau en l'absence du signal (ST) et à haut niveau en présence du signal (ST) et à partir du front de montée d'une première impulsion dudit signal à fréquence double (H/2) jusqu'au front de montée de ladite impulsion ultérieure dudit signal à fréquence double (H/2).

3. Circuit selon la revendication 2, caractérisé en ce que la suite de bascules comprend trois bascules :

- une première bascule (B1) recevant sur son entrée S la sortie d'une porte ET (A1) recevant elle-même le signal de synchronisation de trame (ST) et le signal à fréquence double (H/2), recevant sur son entrée R le signal (ST) inversé, et fournissant sur sa sortie Q un signal (STN),
- une seconde bascule (B2) recevant le signal (STN) et founissant un signal de durée brève (RAZ) sur sa sortie Q,
- une troisième bascule (B3) recevant la sortie de la seconde bascule (B2) sur son entrée S et des signaux logiques en provenance des diviseurs de trame sur son entrée R pour amener la sortie Q de cette bascule (B3) à haut niveau lors du passage à haut niveau du signal (RAZ) et à bas niveau lors de la troisième apparition d'un signal à fréquence double (H/2).

4. Circuit selon la revendication 3, caractérisé en ce que la sortie (STN) de la première bascule (B1) est appliquée à l'entrée de la seconde bascule (B2) par l'intermédiaire d'une porte ET (A2) recevant aussi un signal de fenêtre (F) pour permettre l'application d'un signal sur la deuxième bascule (B2) seulement pendant la durée où il est possible qu'apparaisse normalement un signal de synchronisation trame (ST).

5. Circuit selon l'une des revendications 3 ou 4, caractérisé en ce que la sortie (STN) de la première bascule (B1) est transmise à l'entrée de la deuxième bascule (B2) par l'intermédiaire d'une porte OU (O1) recevant sur sa deuxième entrée un signal (TL) fourni par des circuits logiques du téléviseur à partir du signal (H/2) pour déclencher la deuxième bascule peu après l'instant probable d'apparition du signal de synchronisation de trame (ST), au cas où ce signal n'aurait pas été fourni.

6. Circuit selon l'une quelconque des revendications 3 à 5, caractérisé en ce que la sortie (RAZ) de la seconde bascule (B2) est appliquée aux entrées de remise à zéro d'un ensemble de diviseurs (D1 à D10) connectés séquentiellement et recevant à leur entrée le signal de fréquence double (H/2) pour fournir une suc cession de signaux logiques qui, combinés de diverses manières, peuvent assurer diverses fonctions de synchronisation pour les circuits du téléviseur.

7. Circuit selon l'une quelconque des revendications 3 à 6, caractérisé en ce que le circuit de génération de dent de scie recevant le signal de sortie de la troisième bascule (B3) comprend un condensateur (C) en série avec une source de courant (31) et en parallèle avec un transitor de court-circuit (30), la borne commune à la source de courant (31) et au condensateur (C) étant reliée par l'intermédiaire d'un circuit adaptateur (32) à un comparateur (35) effectuant une comparaison avec une tension de seuil (VS), et en ce que le signal de sortie de la bascule (B3) est appliqué à ladite source de courant (31) et audit comparateur (35) pour les inhiber quand ledit signal de sortie est à haut niveau.

**Claims**

1. A control circuit for providing a vertical deflection saw tooth signal to a TV set comprising an input integrator (20–23) receiving the composite line synchronization signal and supplying a frame synchronization signal (ST), comprising a series of flip-flops (B1, B2, B3) controlled by a signal (ST) and by a signal (H/2) having twice the frequency of the line deflection signal for supplying a frame saw tooth control signal at low level in the absence of signal (ST) and at high level in the presence of signal (ST) and from the rising edge of a first pulse of said double frequency signal (H/2) until the rising edge of a subsequent pulse of said double frequence signal (H/2), characterized in this that the series of flip-flops comprises three flip-flops:

a first flip-flop (B1) receiving at its input S the output of an AND gate (A1) in turn receiving the frame synchronization signal (ST) and the double frequency signal (H/2), receiving at its input R the inverted signal (ST), and supplying at its output Q a signal (STN),
– a second flip-flop (B2) receiving the signal (STN) and supplying a short duration signal (RAZ) at its output Q,
– a third flip-flop (B3) receiving the output of the second flip-flop (B2) at its input S and logic signals from the frame dividers at its input R for setting the output Q of said flip-flop (B3) at a high level during switching to high level of signal (RAZ) and at a low level during the third occurrence of a double frequency signal (H/2).

2. A circuit according to claim 1, characterized in this that the output (STN) of the first flip-flop (B1) is applied to the input of the second flip-flop (B2) through an AND gate (A2) also receiving a window signal (F) to permit applying a signal on the second flip-flop (B2) only while the frame synchronization signal (ST) is normally likely to occur.

3. A circuit according to claim 1 or 2, characterized in this that the output (STN) of the first flip-flop (B1) is transmitted to the input of the second flip-flop (B2) through an OR gate (01) receiving at its second input a signal (TL) supplied by the TV logic circuits from signal (H/2) for triggering the second flip-flop shortly after the probable occurrence of the frame synchronization signal (ST), in case said signal was not supplied.

4. A circuit according to any of claims 1 to 3, characterized in this that the output (RAZ) of the second flip-flop (B2) is applied to the reset inputs of a series of dividers (D1–D10) sequentially connected and receiving at their input the double frequency signal (H/2) for supplying a succession of logic signals which, combined in various ways, are liable to ensure various synchronization functions for the TV circuits.

5. A circuit according to any of claims 1 to 4, characterized in this that the saw tooth generation circuit receiving the output signal of the third flip-flop (B3) comprises a capacitor (C) in series with a current source (31) and in parallel with a shorting transistor (30), the terminal common to the current source (31) and capacitor (C) being connected through a driving circuit (32) to a comparator (36) comparing the threshold voltage (VS), and in that this output signal of flip-flop (B3) is applied to said current source (31) and said comparator (36) for inhibiting them when said output signal is at a high level.

## Patentansprüche

1. Steuerschaltung zum Erzeugen eines sägezahnförmigen Signals für die vertikale Ablenkung in einem Fernsehgerät, die umfaßt: einen Eingangsintegrierer (20-23), der das zusammengesetzte Zeilensynchronisationssignal empfängt und ein Rahmen-Synchronisationssignal (ST) erzeugt, und eine Serie von Flip-Flops (B1, B2, B3), die von dem Auftreten des Signales (ST) und von einem Signal (H/2) gesteuert wird, welches die doppelte Frequenz des Zeilenablenksignales hat, um ein sägezahnförmiges Rahmen-Steuersignal mit niedrigem Pegel abzugeben, wenn das Signal (ST) nicht auftritt, und eines mit hohem Pegel abzugeben, wenn das Signal (ST) auftritt, und zwar ab dem Auftreten der Anstiegsflanke eines ersten Impulses des Signals (H/2) mit der doppelten Frequenz bis zu der Anstiegsflanke eines späteren Impulses des Signales (H/2) mit der doppelten Frequenz, dadurch gekennzeichnet, daß die Serie der Flip-Flops drei Flip-Flops umfaßt:
- ein erstes Flip-Flop (B1), das an seinem S-Eingangsanschluß das Ausgangssignal eines UND-Gatters (A1) empfängt, welches wiederum das Rahmen-Synchronisationssignal (ST) und das Signal (H/2) mit der doppelten Frequenz empfängt, das an seinem R-Eingangsanschluß das Signal (ST) invertiert empfängt und das an seinem Q-Ausgangsanschluß ein Signal (STN) abgibt,
- ein zweites Flip-Flop (B2), das das Signal (STN) empfängt und ein Signal (RAZ) von kurzer Dauer an seinem Q-Ausgangsanschluß abgibt,
- ein drittes Flip-Flop (B3), das das Ausgangssignal des zweiten Flip-Flops (B2) an seinem S-Eingangsanschluß und die logischen Signale von Rahmentei- lern an seinem R-Eingangsanschluß empfängt, um den Q-Ausgangsanschluß dieses Flig-Flop (B3) auf hohen Pegel zu ziehen, wenn das Signal (RAZ) auf hohen Pegel schaltet, und es auf niedrigen Pegel zu ziehen, wenn ein Signal (H/2) mit doppelter Frequenz zum dritten Mal auftritt.

2. Schaltung nach Anspruch 1, dadurch gekennzeichnet, daß das Ausgangssignal (STN) des ersten Flip-Flop über ein UND-Gatter (A2) an den Eingangsanschluß des zweiten Flip-Flop (B2) gegeben wird, das auch ein Fenstersignal (F) empfängt, um das Abgeben eines Signales an das zweite Flip-Flop (B2) nur dann zu erlauben, wenn es möglich ist, daß unter Normalbedingungen ein Rahmensynchronisationssignal (ST) auftritt.

3. Schaltung nach einem der Ansprüche 1 oder 2, dadurch gekennzeichnet, daß das Ausgangssignal (STN) des ersten Flip-Flop (B1) über ein ODER-Gatter (01) an den Eingangsanschluß des zweiten Flip-Flop (B2) gegeben wird, das an seinem zweiten Eingangsanschluß ein Signal (TL) empfängt, welches von den logischen Schaltkreisen des Fernsehgerätes aus dem Signal (H/2) gewonnen wird, zum Triggern des zweiten Flip-Flop kurz vor demjenigen Augenblick, zu dem das Rahmensynchronisationssignal (ST) wahrscheinlich auftritt, wenn das Signal nicht abgegeben worden ist.

4. Schaltung nach einem der Ansprüche 1 bis 3, dadurch gekennzeichnet, daß das Ausgangssignal (RAZ) des zweiten Flip-Flop (B2) an die Null-Rücksetz-Eingangsanschlüsse einer Anordnung von Dividierern (D1-D10) gegeben wird, die in Reihe geschaltet sind und an ihren Eingangsanschlüssen das Signal (H/2) mit der doppelten Frequenz empfangen, um eine Folge logischer Signale abzugeben, die in verschiedenen Kombinationen verschiedene Synchronisationsfunktionen für die Schaltungen des Fernsehgerätes sicherstellen können.

5. Schaltung nach einem der Ansprüche 1 bis 4, dadurch gekennzeichnet, daß die Schaltung zum Erzeugen des Sägezahns, die das Ausgangssignal des dritten Flip-Flop (B3) empfängt, einen Kondensator (C) in Serie mit einer Stromquelle (31) und parallel zu einem Kurzschlußtransistor (30) umfaßt, wobei der gemeinsame Anschluß der Stromquelle (31) und des Kondensators (C) über eine Anpaßschaltung (32) an einen Komparator (36) angeschlossen ist, der einen Vergleich mit einer Schwellenspannung (VS) ausführt, und dadurch, daß das Ausgangssignal des Flip-Flop (B3) der Stromquelle (31) und dem Komparator (36) zugeführt wird, um diese zu sperren, wenn das Ausgangssignal auf hohem Pegel liegt.

# FIG_1-A

# FIG_1-B

# FIG_1-C

# FIG_1-D

# FIG_1-E

# FIG_2

# FIG_3

FIG_4-A

FIG_4-B

FIG_4-C

FIG_5

FIG_6-A

FIG_6-B

FIG_7

FIG_8

FIG_9

EP 0 227 551 B1

FIG_10-a

FIG_10-b

2,35 µs

4,7 µs

32 µs    32 µs    32 µs

E

YR

0

14,5 µs

FIG_10-c

ST

6 µS

FIG_10-d

H/2

32 µS

FIG_10-e

STN

FIG_10-f

2 µS

RAZ

FIG_10-g

Q̄1

Q2

FIG_10-h

FIG_10-i

TN

64 µS

OST

FIG_10-j

0

FIG_10-k

20 µS    12 µS